# EUROPEAN PATENT APPLICATION

(11) **EP 4 667 946 A1**
(43) Date of publication of application: **24.12.2025**
(21) Application number: 24182533.0
(22) Date of filing: 17.06.2024
(51) Int. Cl.: G01R 1/18, G01R 15/06, G01R 15/16, G01R 15/18

(54) **SENSING DEVICE COMPRISING A CAPACITIVE VOLTAGE SENSOR AND A ROGOWSKI COIL CURRENT SENSOR AND CORRESPONDING TRANSMISSION LINE**

(71) Applicant: GE Vernova Technology GmbH, 5400 Baden (CH)
(72) Inventor: Juge, Patrick, 73100 Aix-les-Bains (FR)
(74) Representative: Rüger Abel Patentanwälte PartGmbB

(57) **Abstract**

A sensing device (17) is provided, comprising: a capacitive voltage sensor (21) comprising a substrate (33), a reference plate (34) and a sensing plate (36), each being cylindrical and coaxial relative to a main axis (A) of the sensing device (17), the reference plate (34) arranged on a radially outer side of the substrate (33) and the sensing plate (36) concentrically arranged on a radially inner side of the substrate (33), the reference plate (34) and the sensing plate (36) each being made of an electrically conductive material, the substrate (33) being made of an electrically insulating material, the voltage sensor (21) being adapted to output a voltage signal representative of a voltage value between the reference plate (34) and the sensing plate (36); and a Rogowski coil current sensor (22), the current sensor (22) comprising a toroidal main plate (39) centered on the main axis (A) and made of an electrically insulating material and a ring shaped Rogowski coil (41) carried by the main plate (39), the current sensor (22) being adapted to output a signal representative of a current flowing through a conductor (16) encircled by the Rogowski coil (41). The current sensor (22) is arranged to concentrically encircle the voltage sensor (21) and is fixedly attached to the reference plate (34) of the voltage sensor (21), thereby forming a one-piece construction of the sensing device (17) comprising the current sensor (22) supported directly on the voltage sensor (21).

## Description

### TECHNICAL FIELD

The present invention relates to a sensing device comprising a capacitive voltage sensor and a Rogowski coil current sensor and a transmission line comprising such a sensing device. In preferred applications, the invention may be used in electrical distribution systems, and more particularly in a gas insulated switchgear.

### BACKGROUND

A gas insulated switchgear (GIS) is a type of electrical equipment used to control, protect, and distribute electrical power in high voltage (HV) and medium voltage (MV) systems. A GIS consists of metal-enclosed compartments that house various components, including circuit breakers, disconnectors, bus bars, current and voltage transformers, earth switches, surge arrestors, etc. The components are enclosed within a sealed metal enclosure filled with an insulating gas, usually sulfur hexafluoride (SF₆) or a new generation of climate-friendly high-dielectric gas g3, which is a mixture of C4-FN (C4-fluoronitrile), CO₂, and O₂.

There is a demand for precise real-time current and voltage signals to control the operational state of the electrical grids connected through an HV substation including a GIS. Accurate current and voltage measurements in an GIS are needed, among other things, for operating the circuit breakers and/or disconnectors in case of errors in the connected grids and for billing purposes to allow for accurate billing of the amount of energy transferred to the grids. To this end, voltage and current transformers are included in the GIS.

So called low power instrument transformers (LPIT) have been proposed to provide accurate measurements of voltage, current and power flow derived directly from the primary conductors transferring electrical energy. LPITs are compact and lightweight compared to traditional transformers and offer improved efficiency, safety and communication capabilities.

The use of LPITs in GIS has been investigated, for example, by Reto Christen et al., "Optimized LPIT (Low Power Instrument Transformer) applications in GIS using SF6 and climate-friendly insulating gas g3", session material, CIGRE Session 2022, Paris, France. The primary sensor for current measurement used therein is a non-saturating Rogowski coil on a printed circuit board (PCB) located outside of the gas compartment of the GIS. The voltage measurement used a capacitive divider arranged concentric around the high voltage primary conductor inside the gas compartment of the GIS.

EP 3 276 363 A1 discloses a sensing device that comprises a CEVT based voltage sensor and a RECT based current sensor. The voltage sensor comprises a reference plate and a sensing plate, which are both ring-shaped, concentric and arranged at a distance from each other. An inward-facing surface of the reference plate faces an outward facing surface of the sensing plate. Each of the reference plate and the sensing plate is made of an electrically conductive material, and the voltage sensor is adapted to output a voltage signal representative of a voltage value between the reference plate and the sensing plate. The RECT based current sensor comprises a ring shaped Rogowski coil and is adapted to output a signal representative of a current flowing through a conductor encircled by the Rogowski coil.

A transmission line comprising a grounding pipe, one or more primary conductors arranged within the grounding pipe, and a sensing device comprising a RECT current sensor and a CEVT voltage sensor, which are each arranged around the corresponding primary conductor, is also disclosed. A casing is molded around the voltage sensor and the current sensor and acts as a protective shield to reduce electromagnetic interference that might entail errors in the current measurement using the Rogowski coil.

The entire assembly comprising the current and voltage sensors and the molded casing in which additional components are also mounted may be rather cumbersome, heavy, difficult and costly to produce and assemble. It is desired to provide a sensing device comprising a RECT current sensor and a CEVT voltage sensor, which is more compact, lighter, easier to produce and assemble and less expensive.

WO 2012/072558 A1 discloses a Rogowski coil sensor which comprises a main plate made of electrically insulating material, which is of annular shape centered on a main axis of the sensor and which extends in a radial plane relative to the main axis of the sensor, a ring shaped Rogowski coil carried by the main plate, and a protective screen which surrounds the main plate. The Rogowski coil comprises a winding which is made of an electrically conductive material and includes a plurality of winding arms which cover the two radially extending end faces of the main plate and extend radially relative to the main axis of the sensor, and metallized holes passing through the main plate. The metallized holes connect the winding arms located on one face of the main plate to the winding arms located on the other face of the main plate. The protective screen comprises two secondary plates arranged axially on either side of the main plate, wherein a face of each secondary plate, which is located opposite one of the end faces of the main plate, comprises a metal layer facing the winding. The protective screen protects the winding arms of the Rogowski coil against damage and shields the Rogowski coil against external electrical fields. The winding arms may be formed by printing or depositing conductive material on the end faces of the main plate.

Such Rogowski coil current sensors, which may be applied to a GIS, may have very large radial and axial dimensions and require large amounts of space. For example, an outer diameter of the current sensor may be more than 500 mm or, in some applications, even more than 1200 mm requiring a corresponding large casing and enclosure. In a three-phase configuration, each primary conductor is assigned an own combination of a Rogowski coil current sensor and a capacitive voltage sensor. This may result in a very large footprint and assembly space of the GIS or any component that includes such a sensing device. Such a footprint and assembly space may not always be available. It is desired to reduce the footprint and assembly space.

It is an object of the present invention to provide a sensing device comprising a CEVT based voltage sensor and a RECT based current sensor, which is compacter, lighter, easier to produce and easier to assemble than known sensing devices. The sensing device should provide precise real-time current and voltage measurements and should be usable in various applications, in particular in GIS of HV or MV substations.

Another object of the present invention is to provide a transmission line, in particular a transmission line of a GIS, comprising such a sensing device, with the aim to reduce the required footprint and assembly space.

### BRIEF DESCRIPTION OF THE INVENTION

These objects are solved by a sensing device having the features of independent claim 1 and a transmission line having the features of further independent claim 15.

According to one aspect of the invention, a sensing device is provided, which comprises a capacitive voltage sensor and a Rogowski coil current sensor. The voltage sensor comprises a substrate, a reference plate and a sensing plate, wherein the substrate, the reference plate and the sensing plate each are cylindrical and coaxial relative to a main axis of the sensing device, the reference plate is arranged on a radially outer side of the substrate and the sensing plate is concentrically arranged on a radially inner side of the substrate, spaced from the reference plate. The reference plate and the sensing plate are each made of an electrically conductive material, and the substrate is made of an electrically insulating material. The voltage sensor is adapted to output a voltage signal representative of a voltage value between the reference plate and the sensing plate. The current sensor comprises a toroidal main plate centered on the main axis and made of an electrically insulated material and a ring shaped Rogowski coil carried by the main plate. The Rogowski coil comprises a winding which is made of an electrically conductive material and includes a plurality of winding arms arranged on radially extending end faces of the main plate and extending radially relative to the main axis spaced from each other in a circumferential direction, and metallized holes which pass through the main plate and electrically connect the winding arms located on one end face of the main plate to the winding arms located on another end face of the main plate. The current sensor is adapted to output a signal representative of a current flow through a conductor encircled by the Rogowski coil. The current sensor is arranged to concentrically encircle the voltage sensor and is fixedly attached to the reference plate of the voltage sensor thereby forming a one-piece construction of the sensing device comprising the current sensor supported directly on the voltage sensor.

The invention provides a low power instrument transformer (LPIT) device comprising the Rogowski Effect Current Transformer (RECT) based current sensor and the Capacitive Effect Voltage Transformer (CEVT) based voltage sensor, which are designed and assembled to form a one-piece sensing device where the voltage sensor and the current sensor are co-located and mechanically connected to each other such that the current sensor is directly carried by the voltage sensor. This results in a cost-effective, less cumbersome and less expensive construction which requires less parts for assembly and mounting and is easier to produce and easier to assemble than known sensing devices. The sensing device is arranged to provide reliable and precise voltage and current measurements and is suitable for use in a great variety of applications, including gas insulated switchgears (GIS) of high voltage (HV) and medium voltage (MV) substations.

In preferred embodiments of the sensing device, the substrate of the voltage sensor may be a flexible circuit board and the reference plate and the sensing plate may be metallic strips printed on the flexible circuit board. This may be easily and cost-effectively implemented. The design offers the advantage of long-term stability, no partial discharges, extremely high thermal stability and tolerance to vibrations of the conductor, e.g. the high voltage primary conductor inside a gas compartment of a GIS, around which the sensing device is arranged.

The flexible circuit board may advantageously be made of a flame resistant epoxy material, preferably a glass-reinforced epoxy laminate material, such as FR-4. FR-4 is a composite material composed of woven fiberglass cloth with an epoxy resin binder that is flame resistant and self-extinguishing when exposed to heat or an open flame. This property makes FR-4 especially suitable for use in electronic devices and printed circuit boards and, in particular, for use in GIS of HF and MV substations, where a high flame resistance is especially important. In any case, the flexible circuit board material, such as FR-4, may also offer high mechanical strength and high electrical insulating qualities in both dry and humid conditions.

In preferred embodiments of the sensing device of any type described above, the main plate of the current sensor may be a flexible circuit board and the winding arms of the Rogowski coil may be conductive traces printed on the end faces of the flexible circuit board. Printing may include any technique known in the art, like direct printing or depositing of conductive material on the end faces of the main plate or covering the end faces of the main plate with a uniform layer of conductive material and then removing parts of the conductive material using masks and acid to leave only the portions of conductive material which form the winding arms. The Rogowski coil may be designed to be a non-saturating Rogowski coil which provides the desired undistorted, hysteresis-free output signal that is a voltage proportional to the first derivative of the primary current flowing through the primary conductor, e.g. the high voltage primary conductor of a GIS, which passes through the sensing device. The nonmagnetic material of the printed circuit board is the basis for providing a reliable and predictable Rogowski coil current sensor with a high homogeneity of the windings, that allows a very good immunity to external electrical fields coming from currents of neighboring phases, for example.

Advantageously, the flexible circuit board of the main plate may be made of a flame resistant epoxy material, more preferably a glass-reinforced epoxy laminate material, such as FR-4, which may provide the benefits already mentioned above in connection with the flexible circuit board material of the voltage sensor substrate.

In the sensing device of any of the types described above, the reference plate and the sensing plate may be made of copper or aluminum and/or the winding arms and the metalized holes may be made of copper or aluminum. Copper is particularly preferred in case the reference and sensing plates and the winding arms are formed as conductive planes or traces printed on flexible circuit boards. The copper planes and traces may be printed or etched onto the substrate to form the desired circuit patterns. Other suitable conductive materials, such as gold, silver and the like, might also be used depending on the specific applications and requirements.

In particularly preferred embodiments of the sensing device, the substrate of the voltage sensor and the main plate of the current sensor are made of the same flexible circuit board material, in particular a flame resistant epoxy material, preferably FR-4, and the reference plate, the sensing plate and the winding of the Rogowski coil are all made of the same metallic material, in particular copper or other metallic material suitable to be printed onto the flexible circuit board. Both sensors are thus based on the same materials and may be easily and cost-effectively produced and assembled into a single piece with reduced number of components and materials and using the same technique to produce the printed circuit boards. The resulting sensing device may be very compact, lightweight and relatively cheap compared to known sensing devices and permits an easy integration inside an axially shorter and radially smaller GIS enclosure. In addition, use of the same materials results in similar thermal expansion and contraction properties of the voltage sensor and the current sensor under varying environmental and operating conditions.

In the sensing device of any type described above, the current sensor is preferably soldered to the reference plate of the voltage sensor. The soldering may be easily and cost-effectively implemented and provides a stable and long-term mechanical bond between the current sensor and the voltage sensor.

In the sensing device of any type described above, the current sensor may further comprise a metallic protective screen arranged to protect the main plate and the winding of the Rogowski coil from possible damage, e.g. by mechanical exposure, and to shield the Rogowski coil against external electric fields. The protective screen may include protective plates arranged axially on either side of the main plate and extending parallel to the main plate and coaxial with the main axis of the sensing device. The protective plates protect the winding arms of the Rogowski coil against shocks and other external attacks and also protect the Rogowski coil against electromagnetic disturbances which could harm precise current measurements.

Preferably, the metallic protective screen may be arranged to substantially surround the entire main plate and winding of the Rogowski coil, that is to cover both radially extending end faces and the radially inner and outer sides of the main plate. The term "substantially surround" means in this connection that there may be spaces, through holes and the like at one or more of the sides of the main plate to allow connecting wires to pass through, for example.

In especially preferred embodiments, a portion of the reference plate forms a radial inner part of the metallic protective screen and is arranged to shield the Rogowski coil from the sensing plate. The reference plate of the voltage sensor is located on the radially outer side of the voltage sensor and is grounded and is thus capable of blocking the electric field lines extending from or to the sensing plate. In view of the reference plate, no additional shield is required for the Rogowski coil at the radially inner side of the current sensor. The reference plate and the other portions of the protective screen may provide, in combination, the protection of the Rogowski coil against electric fields from any direction.

In the embodiment of the sensing device comprising the protective screen, the protective plates may be soldered to the reference plate at the interface between radially inner portion of the protective plates and the reference plate using an electrically conductive solder. This provides the required stable mechanical bond and the closed and continuous protective screen substantially around the entire circumference of the current sensor. The protective screen may be grounded and thus the reference plate is also grounded via the solder connection.

In some embodiments of the sensing device of the last-mentioned type including protective plates soldered to the reference plate, a part of the metallic material of the protective plates may be omitted or removed from a radially inner interface portion of the protective plates prior to soldering the protective plates to the reference plate to reduce conductivity at the interface of the protective plates and the reference plate to facilitate reducing heat input during the soldering process. This provides certain protection of the Rogowski coil against thermal damage during the soldering process.

The sensing device of any type described above may further comprise at least one temperature sensor attached to the current sensor at a predetermined position and configured to measure a temperature in a corresponding predetermined volume relative to the current sensor and the voltage sensor. The measurement signals provided by the temperature sensor(s) may allow for a correction of the sensed current and voltage values to compensate for the effects of temperature fluctuations on the sensor geometry, that is the thermal expansions and contractions of the components of the sensing device. The printed circuit board material behavior as a function of the temperature is generally well known and the compensation to account for thermal expansion and contraction and/or the compensation for temperature dependent resistance variation can be readily implemented. This offers a basis for stable and precise voltage and current measurements of outstanding accuracy and linearity under varying conditions.

In some embodiments, the sensing device of any type described above may comprise two RECT based current sensors which are attached to the voltage sensor and are to be placed around an individual primary conductor, wherein the two current sensors are superimposed axially and are supported against each other while being generally insulated from one another. The two current sensors may be electrically connected to each other either in series or in parallel. The series connection may provide a larger sensitivity of the resulting combined current sensor with reduced radial dimensions thereof. The parallel connection of the current sensors may offer redundancy to enhance security and reliability of the current measurements.

According to another aspect of the invention, a transmission line, in particular a transmission line of a gas insulated switchgear (GIS) is provided. The transmission line comprises a grounding pipe made of an electrically conductive material, the grounding pipe defining an internal cavity that is filled with a dielectric gas for insulation and protection, one or more conductors arranged in the cavity within the grounding pipe and made of an electrically conductive material, wherein the grounding pipe and each conductor extend along a same longitudinal axis and each conductor is spaced apart from the grounding pipe, and a sensing device of any type described above assigned to each of the one or more conductors, wherein the sensing device is arranged around the corresponding conductor between the grounding pipe and the corresponding conductor in the internal cavity filled with the dielectric gas.

The entire sensing device including the combination of the CEVT based voltage sensor and the RECT based current sensor is localized inside the dielectric gas, e.g. SF₆ or preferably g3, or another insulating gas, which is used for insulation and protection in the internal cavity of the transmission pipe. In conventional low power instrument transformers only the voltage sensor is arranged inside the gas compartment of a GIS, for example, while the current sensor is located outside the gas compartment to assure reliable, precise and unimpaired current measurements. It has been found that the entire one-piece sensing device may be located inside the gas compartment without affecting reliability and precision of the current measurements and the security of the assembly.

In other respects, the sensing device in the transmission line may have any embodiment and benefit from any embodiment of the sensing device presented above in connection with the first aspect of the invention. In order to avoid repetitions, reference is made to the description of the sensing device presented above.

The transmission line may further comprise a computer device electrically connected to the sensing device and configured to compute the value of the conductor-to-pipe voltage between the grounding pipe and the corresponding conductor from the output voltage signal provided by the voltage sensor using the capacitive divider principle and of the current flowing through the conductor by integrating the output signal provided by the current sensor. The computer device may further be configured to correct the measured conductor-to-pipe voltages and current measurements using the sensed temperature signals provided by corresponding temperature sensors, if available, to compensate for the effects of the temperature fluctuations on the geometry and properties of the sensor components.

These and other advantages and features of the present invention will become more apparent from the following description taken in conjunction with the drawings.

### BRIEF DESCRIPTION OF THE DRAWINGS

The subject-matter, which is regarded as the invention, is particularly pointed out and distinctly claimed in the claims at the conclusion of the specification. The foregoing and other features and advantages of the invention are apparent from the following detailed description taken in conjunction with the accompanying drawings, wherein:
Fig. 1 is a schematic view, partly in cross-section, of a gas-insulated switchgear to illustrate the preferred environment in which the invention may be used;
Fig. 2 is a cross-section of a transmission line which may be used in the gas-insulated switchgear of Fig. 1 and including a sensing device according to an embodiment of the invention, in a simplified view;
Fig. 3 shows an enlarged section I of Fig. 2 illustrating details of the sensing device of the present invention including a Rogowski coil current sensor and a capacitive voltage sensor, in a simplified view;
Fig. 4 is a schematic axial plan view of the sensing device of Figs. 2 and 3 and illustrating the structure of the Rogowski coil current sensor according to an embodiment;
Fig. 5 is a cross-section of the Rogowski coil current sensor along line II-II in Fig. 4;
Fig. 6 is a cross-section similar to that of Fig. 5 showing a sensing device including a Rogowski coil current sensor according to another embodiment of the invention; and
Fig. 7 is a schematic cross-section of a three-phase embodiment of a transmission line according to an embodiment of the invention, in a plane orthogonal to the longitudinal axis.

### DESCRIPTION OF PREFERRED EMBODIMENTS

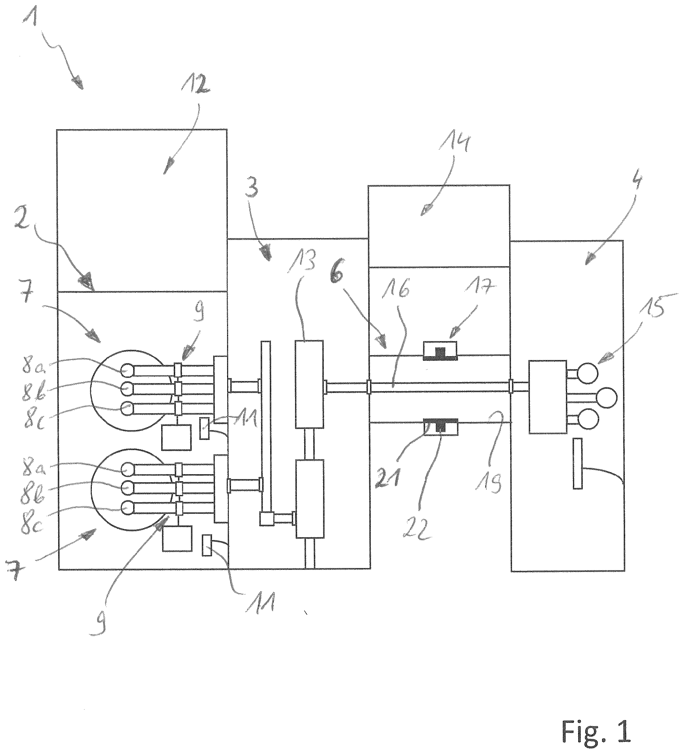

Fig. 1 shows a gas-insulated switchgear (GIS) 1 to demonstrate a preferred environment in which the invention may be used. In the embodiment shown, the GIS 1 is comprised of a bus bar unit 2, a circuit breaker unit 3, a line side unit 4, and an instrumented transmission line 6 connecting the circuit breaker unit 3 to the line side unit 4. The units 2-4 and the transmission line 6 consist of metal-enclosed compartments that house the respective components and use a gas, such as SF₆ or preferably the more climate-friendly gas g3, or other insulating gas or gas mixture, as the primary insulation between the life parts and the earthed metal enclosures. The insulating gas provides high dielectric strength, high thermal stability and good arc quenching properties.

In the exemplary embodiment of Fig. 1, the bus bar unit 2 includes two bus bar subunits 7 each comprising bus bar conductors 8a, 8b, 8c of three phases. The bus bar conductors 8a-c are connected to generators, transformers, feeders, etc., which may form a first grid (not shown herein, to the left in Fig. 1). The bus bar conductors 8a-c are connected via disconnectors 9 and earth switches 11, which are only schematically shown herein, to the circuit breaker unit 3. The disconnectors 9 are arranged to isolate a part of the circuit from the rest of the system for maintenance or testing purposes, if needed. The earth switches 11 can connect a part of the circuit to the earth for safety or grounding purposes. A control box 5 is disposed on top of the bus bar unit 2 for controlling operation of its components.

The circuit breaker unit 3 comprises a number of circuit breakers 13 corresponding to the number of phases and bus bar conductors 8a-c in the system. Only one circuit braker is shown herein for convenience. The circuit breakers 13 are arranged to interrupt the flow of current when a fault occurs. A circuit breaker operating mechanism 14 is provided for operating the circuit breakers 13 as required. In the present exemplary embodiment, the circuit breaker operating mechanism 14 is positioned in a space between the circuit breaker unit 3 and the line side unit 4 above the transmission line 6, but may be arranged at any location any anywhere as desired.

The line side unit 4 of the GIS 1 mainly includes an integrated cable interface 15 to which electrical power transmission cables of a subsequent power grid (not shown herein, to the right in Fig. 1) can be connected for power transmission thereto. The line side unit 4 may comprise further components, like earth switches, surge arresters, and the like, for safety purposes.

The transmission line 6 is interposed between the circuit breaker unit 3 and the line side unit 4 and includes a number of primary conductors 16 corresponding to the number of phases in the system. Only one primary conductor 16 is shown herein for convenience. The primary conductors 16 connect corresponding conductors (not separately labeled) in the circuit breaker unit 3, which are connected to the bus bar connectors 8a, 8b, 8c, to the cable interface 15 in the line-side unit 4 to allow electricity to flow therethrouh.

Under normal conditions, the contacts of the circuit breakers 13 are closed and current flows through them and through the primary conductors 16 and the cable interface 15 to the power grid connected thereto and vice versa. When a fault occurs in the circuit, such as a short circuit or an overload, the contacts of the circuit breakers 13 separate, and an arc occurs between them. The arc generates heat and pressure that can damage the contacts and other components and must be extinguished as quickly as possible. The GIS 1 provides for arc extinguishing through the mechanisms of action of thermal and dielectric interruptions.

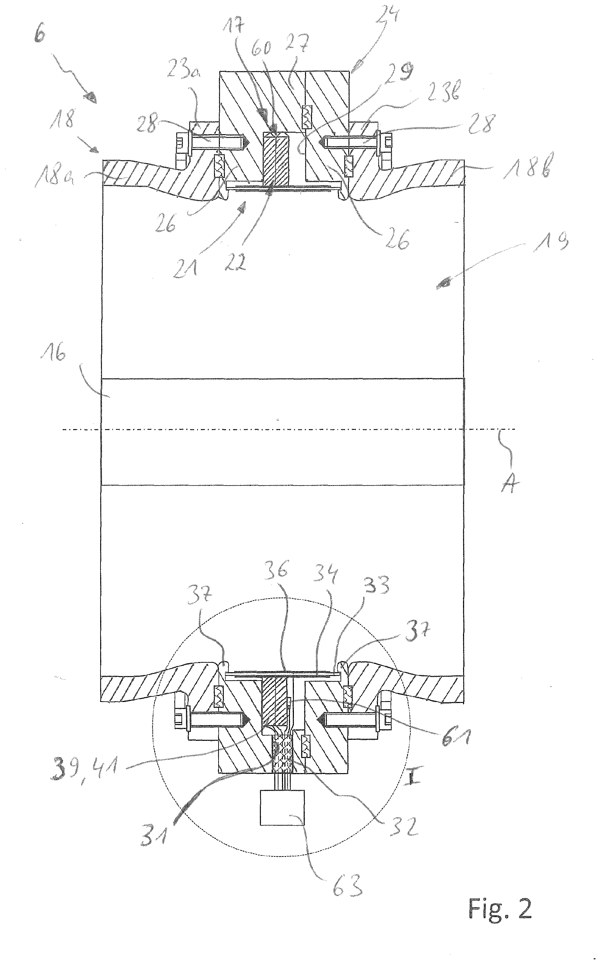

It is necessary to measure the amount of current, voltage and power transmitted between the electrical grids connected to each other through a high voltage (HV) or medium voltage (MV) substation including a GIS 1. Accurate current and voltage measurements are needed for operating the circuit breakers 13 in case of errors in the connected grids. Accurate current and voltage measurements may also be used for billing purposes to allow for accurate billing of the amount of energy transferred to or between the grids. To this end, the transmission line 6 is instrumented with a sensing device 17 that is arranged to provide precise real-time current and voltage measurement signals associated with the power flow through the primary conductors 16. The sensing device 17 of the present invention is described in more detail below in connection with Figs. 2-7.

It should be noted that the sensing device 17 of the present invention is shown in Fig. 1 as included in the transmission line 6 connecting the circuit breaker unit 3 to the line side unit 4 of the GIS 1. However, the transmission line 6 with the sensing device 17 may be positioned at any location in the GIS 1. The GIS 1 must not have the configuration shown in Fig. 1. A great number of GIS configurations is known in the art, which may be used herein, where the components, e.g. the bus bar unit and the circuit breaker unit, may be positioned adjacent to each other in the horizontal direction or one above the other in the vertical direction and where there may be further components provided in the respective units 2-4 and/or in additional units and the components may be arranged differently than shown in Fig. 1. The sensing device 17 of the present invention may not necessarily be applied to gas-insulated switchgears, but may be used in a great variety of applications for power transmission.

Turning now to Figs. 2-8, the transmission line 6 including the sensing device 17 according to embodiments of the invention is shown therein in a schematic cross-sectional view. The transmission line 6 comprises one or more primary conductors 16 (only one shown), referred to as a conductor 16 below, a grounding pipe 18 enclosing the conductor 16, and the sensing device 17. The conductor 16 is provided to convey electric current from a first end of the transmission line 6 to a second end of the transmission line 6.

The grounding pipe 18 is made of an electrically conductive material, in particular a metal or metal alloy, and defines an internal cavity 19 that is filled with the dielectric gas for insulation and protection. The dielectric gas is preferably g³ or may also be SF₆. The transmission line 6 may be part of a gas insulated switchgear (GIS), such as the GIS 1 shown in Fig. 1.

As can be seen in Fig. 2, the grounding pipe 6 is arranged to be rotationally symmetrical about a longitudinal central axis A. The grounding pipe 18 is configured to be electrically connected to a reference electric potential source, for instance the ground. The grounding pipe 18 is also configured to allow the circulation of a reverse current flowing in an opposite direction relative to the current flowing in the conductor 16.

The conductor 16 is made of an electrically conductive material and extends along the same longitudinal central axis A as the grounding pipe 18. The conductor 16 is spaced apart from the grounding pipe 18 in the radial direction.

The sensing device 17 is designed as a so-called low power instrument transformer (LPIT), which comprises a capacity effect voltage transformer (CEVT) based voltage sensor 21 configured to measure the value of the conductor-to-pipe-value equal to the difference in electric potential between the grounding pipe 18 and the conductor 16, and a Rogowski effect current transformer (RECT) based current sensor 22 configured to measure the value of the electric current flowing through the conductor 16. According to the invention, the voltage sensor 21 and the current sensor are co-located and assembled together to form a unitary, one-piece construction.

In the specific embodiment shown in Fig. 2, the grounding pipe 18 is designed in multiple parts to facilitate assembly of the instrumented transmission line 6 and includes a first and a second grounding pipe portion 18a, 18b that are formed as hollow cylinders extending along the central axis A adjacent to each other. Each grounding pipe portion 18a, 18b includes a radially extending flange 23a, 23b for the purpose of fastening. A ring shaped pipe coupling 24 is inserted in the axial space between the flanges 23a, 23b of the grounding pipe portions 18a, 18b and has a substantially U-shaped cross-section with two radial legs 26 and an axial portion 27 connecting the radial legs 26 to each other. The radial legs 26 are fastened to the flanges 23a, 23b of the grounding pipe portions 18a, 18b using fasteners 28, e.g. screw bolts going through openings in the flanges 23a, 23b and screwed into threaded holes formed in the radial legs 26 of the pipe coupling 24.

In the configuration of the pipe coupling 24 shown in Fig. 2, the axial portion 27 of the pipe coupling 24 is positioned to protrude radially outwards beyond the flanges 23a, 23b, and the radial legs 26 define together with the axial portion 27 a groove 29 therebetween, on the inwardly facing surface sides thereof, such that the groove 29 opens toward the internal cavity 19 of the transmission line 6.

The groove 29 is of a ring shape, which is defined in a plane orthogonal to the central axis A, and is positioned approximately at the radial level of the flanges 23a, 23b. The groove 29 may comprise at least one through hole 31 formed through the axial portion 27 of the pipe coupling 24 to connect the internal cavity 19 to the outside of the grounding pipe 18. A compression sealing gasket 32 is arranged in the through hole 31 to prevent the insulating gas filling the internal cavity 19 from escaping to the outside via the through hole 31.

The groove 29 is arranged to receive a part of the sensing device 17, in particular the current sensor 22 therein.

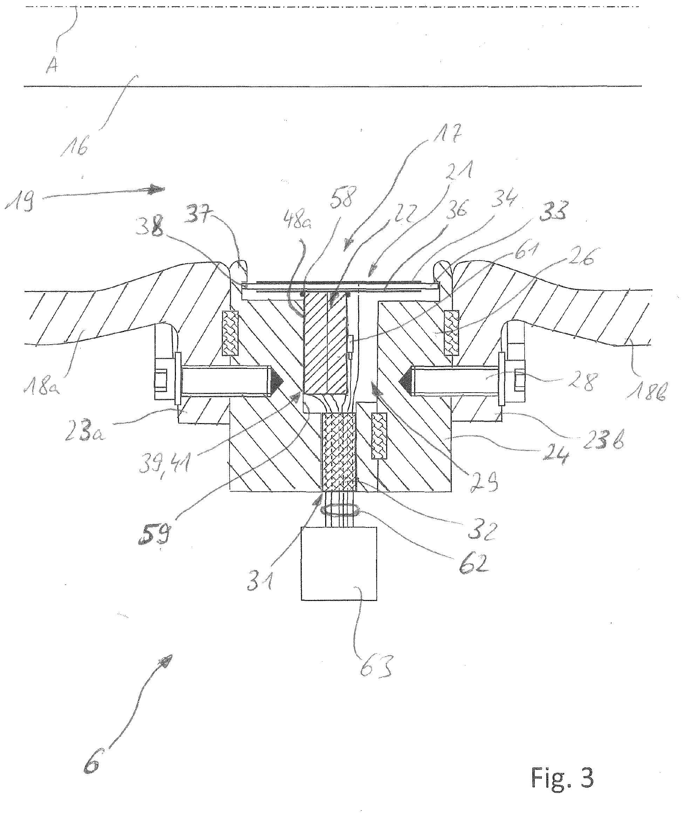

The sensing device 17 including the voltage sensor 21 and the current sensor 22 is also shown in Fig. 3 which illustrates an enlarged detail view of the section I of figure 2. The capacitive voltage sensor 21 comprises a substrate 33, a reference plate 34, and a sensing plate 36. The substrate 33, the reference plate 34, and the sensing plate 36 are each cylindrical and coaxial relative to a main axis which, in the mounted state of the sensing device 17, as shown in Figs. 2 and 3, coincides with the longitudinal central axis A of the transmission line 6. For convenience, the central axis A of the transmission line 6 is also referred to as the main axis A of the sensing device 17.

As may be seen from Figs. 2 and 3, the reference plate 34 is arranged on a radially outer side 35a of the substrate 33 and the sensing plate 36 is concentrically arranged on a radially inner side 35b of the substrate 33 and is thus spaced from the reference plate 34 by the thickness of the substrate 33. The reference plate 34 and the sensing plate 36 are each made of an electrically conductive material, in particular a metallic material, like copper or aluminum, and the substrate is made of an electrically insulating material thereby insulating the reference plate 34 from the sensing plate 36. The arrangement of the reference and sensing plates 34, 36 insulated by the substrate 33 thus forms a cylindrical capacitor.

In preferred implementations, the substrate 33 of the voltage sensor 21 is a flexible circuit board and the reference plate 34 and the sensing plate 36 are metallic strips or planes located on the opposite sides 35a, 36b of the flexible circuit board. They may be printed on the flexible circuit board in a conventional manner.

As may be seen from Figs. 2 and 3, in use, the sensing device 17 is arranged in the axial section of the grounding pipe 18 which is occupied by the pipe coupling 24 such that the current sensor 22 is received between the flanges 23a, 23b of the grounding pipe portions 18a, 18b. The pipe coupling 24 may comprise holding arms 37 formed on both axial ends of the pipe coupling 34 so as to project radially inwardly. The holding arms 37 are formed to reach under and support axial edges 38 of the substrate 33. The axial edges 38 of the substrate 33 might additionally be secured to the holding arms 37 by glueing, screwing or other attachment methods, if desired.

For the intended application, in particular in a GIS, the flexible circuit board of the substrate 33 is preferably made from a flame resistant epoxy material, preferably a gas-reinforced epoxy laminate material, such as FR-4. FR-4 is a composite material composed of woven fiberglass cloth with an epoxy resin binder that is flame resistant and self-extinguishing when exposed to heat or an open flame. These properties in combination with its high mechanical strength and good electrical insulating qualities in both dry and humid conditions make FR-4 suitable for use in printed circuit boards and, in particular, for the intended application in a GIS.

The reference plate 34 is electrically connected to the grounding pipe 18 to make the electric potential of the reference plate 34 equal to the electric potential of the grounding pipe 18. As will be explained in more detail below, the reference plate 34 is grounded to the grounding pipe 18 via a part, a metallic protective screen, of the current sensor 22. Thus, in the example shown, the reference plate 34 is formed on the outer side of the substrate 33 such that its axial ends do not contact the holding arms 37 of the pipe coupling 24. As an alternative, the reference plate 34 might be formed to cover the entire outer surface of the substrate 33 and to directly connect to the holding arms 37 of the pipe coupling 24 such that the reference plate 34 might be connected to the grounding pipe 18 via the pipe coupling 24.

The sensing plate 36 is located on the inner side of the substrate 33 such that its axial ends are located at a distance from and do not contact the holding arms 37 of the pipe coupling 24.

The voltage sensor thus formed and arranged is adapted to output a measurement voltage signal representative of a voltage value between the reference plate 34 and the sensing plate 36.

The Rogowski coil current sensor 22 comprises a toroidal main plate 39 centered on the main axis A and made of an electrically insulating material and a ring shaped Rogowski coil 41 carried by the main plate 39. The Rogowski coil 41 comprises a winding 42 which is made of an electrically conductive material. As is generally known, the winding 42 of a Rogowski coil 41 generally forms two concentric turns formed from a single conductor.

As may be seen from Figs. 2-4, the current sensor 22 has an annular shape around the main axis A and is arranged to concentrically surround the voltage sensor 21. The current sensor 22 is located within the grounding pipe 18 and around the conductor 16. In the example shown, the current sensor 22 is received in the groove 29 of the pipe coupling 24 and is concentric with the reference plate 34 and the sensing plate 36 of the voltage sensor 21.

In order to make the sensing device 17 more compact, lighter, cheaper, easier to produce and easier to assemble than known sensing devices, the voltage sensor 21 and the current sensor 22 are co-located and combined together such that the current sensor 22 is directly placed around the voltage sensor 21, that is the reference plate 34, wherein the inner diameter of the current sensor 22 substantially corresponds to the outer diameter of the voltage sensor 21. The current sensor 22 is fixedly attached, in particular soldered, to the reference plate 34 of the voltage sensor 21, thereby forming a one-piece construction of the sensing device 17 comprising the current sensor 22 supported directly on the voltage sensor 21.

This results in a cost-effective, less cumbersome and less expensive construction which requires less parts for assembly and mounting and may be easily produced and assembled.

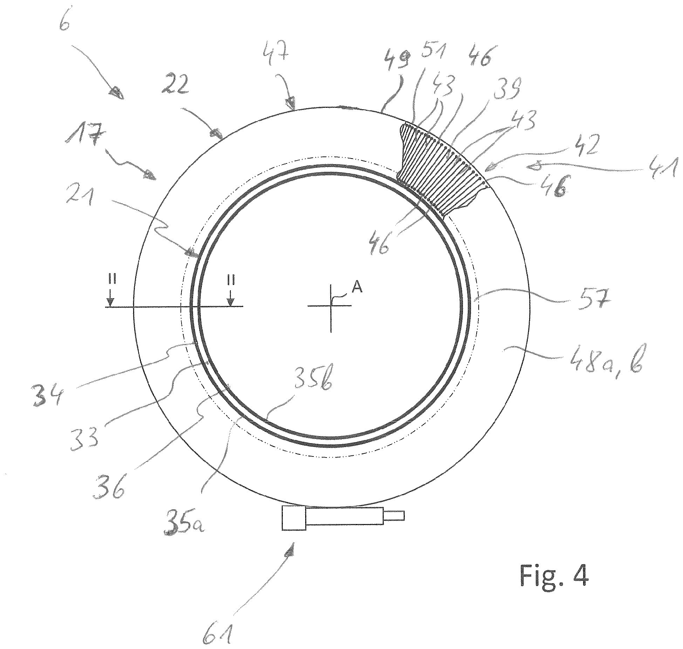

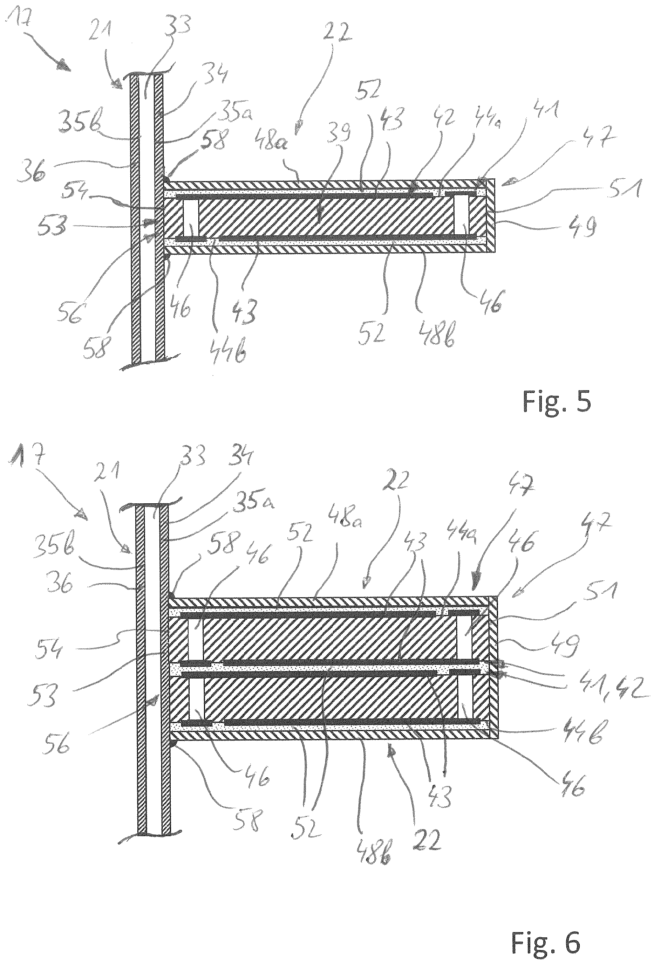

With additional reference to Figs. 4 and 5, the main plate 39 of the current sensor 22 is of an annular shape centered on the main axis A of the sensing device 17. The main plate 39 is substantially flat and extends in a radial plane that is substantially orthogonal to the main axis A.

The main plate 39, which itself is made of an electrical insulating material, carries the Rogowski coil 41 which comprises the winding 42 made of an electrically conductive material. In the embodiment shown, the winding 42 includes a plurality of winding arms 43 which are attached to the main plate 39. The winding arms 43 are arranged on and cover the two radially extending end faces 44a, 44b of the main plate 39. The winding arms 43 extend radially relative to the main axis A and are spaced from each other in a circumferential direction around the main axis A. The winding 42 further comprises metallized holes 46 which pass through the main plate 39 at the level of the ends of the winding arms 43 and electrically connect the winding arms 43 located on one end face 44a of the main plate 39 to the winding arms 43 located on the opposite end face 44b of the main plate 39. The current sensor 22 thus formed is adapted to output a signal representative of a current flowing through the conductor 16 encircled by the Rogowski coil 41.

The winding arms 43 are located on the end faces 44a, 44b of the main plate 39 such that the radial ends of the winding arms 43 are set back relative to the circular edges of the main plate 39. In other words, the internal radial end of each winding arm 43 is located at a greater radial dimension than the radial dimension of the internal edge of the main plate 39 and the external radial end of each winding arm 43 is located at a radial dimension that is smaller than the radial dimension of the external edge of the main plate 39.

In preferred implementations, the main plate 39 of the current sensor 22 may be a flexible circuit board and the winding arms 43 of the Rogowski coil 41 may be conductive traces printed on the end faces 44a, 44b of the flexible circuit board. The flexible circuit board is preferably made of a flame resistant epoxy material, in particular a gas-reinforced epoxy laminate material, such as FR-4. As mentioned above, this material is particularly suited for the presently intended applications. The printing may include any technique known in the art, like direct printing or depositing of conductive material on the end faces 44a, 44b of the main plate 39 with a uniform layer of conductive material and then removing parts of the conductive material using masks and acid to leave only the portions of conductive material which form the winding arms 43. The Rogowski coil 41 may be designed to be a non-saturating Rogowski coil which provides the desired undistorted, hysteresis-free output signal that represents a voltage proportional to the first derivative of the primary current flowing through the conductor 16 which passes through the sensing device 17.

The Rogowski coil 41 including the winding arms 43 and the metallized holes 46 may be made of copper or aluminum or other suitable electrically conductive materials.

In particularly preferred embodiments of the sensing device 17, the substrate 33 of the voltage sensor 21 and the main plate 39 of the current sensor 22 are made of the same flexible circuit board material, in particular FR-4 or a comparable flame resistant epoxy material. The reference plate 34, the sensing plate 36 and the Rogowski coil 41 are preferably all made of the same metallic material, in particular copper. Both sensors 21, 22 are then based on the same materials and may be easily and cost-effectively produced and assembled together into a single piece with reduced number of components and materials and using the same technique to produce both the printed circuit boards. The resulting sensing device 17 may be very compact, lightweight and relatively cheap and permits and easy integration inside an axially shorter and radially smaller device, in particular a GIS enclosure. In addition, use of the same materials results in similar thermal expansion and contraction properties of the voltage sensor 21 and the current sensor 22 under varying environmental and operating conditions.

In order to protect the main plate 39, in particular the printed circuit board including the winding arms 43, from possible damage resulting from shocks and external attacks and also to protect the Rogowski coil 41 against electromagnetic disturbances which could harm a precise current measurement, A protective screen 47 is provided. The protective screen 47 is made from a metallic material. The protective screen 47 may be configured to substantially surround the main plate 39 including the Rogowski coil 41.

The protective screen 47 includes at least protective plates 48a, 48b which are arranged axially on either side of the main plate 39 such that they extend parallel to the main plate 39 and coaxial with the main axis A of the sensing device 17. The protective plates 48a, 48b are made from a metallic material.

In addition to the protective plates 48a, 48b that cover the annular end faces 44a, 44b of the main plate 39, the protective screen 47 may further comprise a cylindrical plate 49 which covers the radially outer surface 51 of the main plate 39. The cylindrical plate 49 is also made from a metallic material and may be a metal layer printed on the radially outer surface 51 of the metal plate 39. The cylindrical plate 49 may preferably be continuously, integrally formed together with protective plates 48a, 48b or may be electrically connected to them in some other way. In some embodiments, the cylindrical plate 49 might be omitted.

The protective plates 48a, 48b are located axially at a distance from the main plate 39, such that the metal layer provided by the protective plates 48a, 48b is spaced axially at a distance from the winding arms 43 and metallized holes 46 of the Rogowski coil 41 which are located on the end faces 44a, 44b of the main plate 39. Each protective plate 48a, 48b is separated from the main plate 39 by means of a layer of insulating material 52 that is provided directly on the end faces 44a, 44b. The radially outer surface 51 of the main plate may optionally also comprise a layer of insulating material 52, although this is not necessarily required. The layer of insulating material 52 also serves to secure the protective plates 48a, 48b and the cylindrical plate 49, if any, to the main plate 39 by glueing. As an alternative, a mechanical attachment might be used.

In the preferred embodiment shown in Figs. 2-5, a portion 53 of the reference plate 34 located directly adjacent the radially inner surface 54 of the main plate 39 forms a radially inner part 56 of the metallic protective screen 47 and is arranged to shield the Rogowski coil 41 against electric fields. In particular, since the reference plate 34 of the voltage sensor 21 is interposed between the sensing plate 36 of the voltage sensor 21 and the current sensor 22 and is grounded, the reference plate 34 is thus capable of blocking the electric field lines coming from or to the sensing plate 36. Thus, no additional shield is required for the Rogowski coil at the radially inner side of the current sensor 22.

The protective screen 47 including the protective plates 48a, 48b, the cylindrical plate 49 and the portion 53 of the reference plate 34 together form a grounded metal cage which substantially surrounds the entire winding 42 of the Rogowski coil 41, thereby protecting it from external electric fields and disturbances. The protective screen 47 also increases stability and rigidity of the entire multilayer structure of the current sensor 22. Together with the layers 52 of insulating material, the protective screen 47 further prevents foreign particles from being deposited between the winding arms 43 of the winding 42, thus avoiding the risk of a short circuit in the winding 42.

In order to fix the current sensor 22 to the voltage sensor 21 and to form a protective screen 47 substantially around the entire circumference of the main plate 39, the protective plates 48a, 48b may be soldered to the reference plate 34 at the interface between a radially inner portion 57 of the protective plates 48a, 48b and the portion 53 of the reference plate 34 using an electrically conductive solder. A soldered seam 58 may be formed around the entire circumference of the reference plate 34 at the interface to the protective plates 48a, 48b on both axial sides of the current sensor 22. The soldered seams 58 provide a stable mechanical bond between the current sensor 22 and the voltage sensor 21 and complement the protective metal cage formed by the protective screen 47 which surrounds the winding 42 of the Rogowski coil 41. Since the protective screen 47 is grounded, the reference plate 34 is also grounded via the soldered seams 58.

In preferred embodiments, the protective plates 48a, 48b may be adapted to facilitate soldering of the protective plates 48a, 48b to the reference plate 34 while avoiding overheating of the parts and possible damage caused thereby. To this end, a part of the metallic material of the protective plates 48a, 48b may be omitted or removed from the radially inner portion 57 of the protective plates 48a, 48b when producing the protective plates 48a, 48b or at least prior to performing the soldering. In doing so, the electrical conductivity at the interface of the protective plates 48a, 48b and the reference plate 34 is reduced which facilitates minimizing or at least reducing heat input during the soldering process to thereby avoid or at least reduce the risk of a thermal damage to the Rogowski coil 41 during the soldering process.

The sensing device 17 according to the invention is produced by first printing or depositing the winding arms 43 on the axial end faces 44a, 44b of the flexible circuit board of the main plate 39. Then, holes passing through the main plate 39 are drilled at the ends of the winding arms 43 and are metallized by depositing a metallic material on the walls of each hole, thus forming the metallized holes 46. The metallized holes 46 are then filled with an electrically conductive material to electrically connect the winding arms 43 disposed on the opposite end faces 44a, 44b to each other. Subsequently, the protective plates 48a, 48b and the cylindrical plate 49, if any, are placed or formed on the end faces 44a, 44b and the radially outer surface 51 of the main plate 39 and are assembled thereto via the layer of insulating material 52. The voltage sensor 21 is formed by printing or depositing metallic layers on the opposite radial inner and outer surfaces 35a, 35b of the flexible circuit board of the cylindrical substrate 33 forming the reference plate 34 and the sensing plate 36 thereon. The voltage sensor 21 is designed such that the resulting outer dimension thereof matches the inner dimension of the current sensor 22. The current sensor 22 is then placed around the voltage sensor 21 and is fixed thereto by soldering the protective plates 48a, 48b to the reference plate 34 forming the soldered seems 58.

The sensing device 17 thus formed is designed and assembled to form a one-piece construction having the voltage sensor 21 and the current sensor 22 co-located and mechanically connected to each other such that the current sensor 22 is directly carried by the voltage sensor 21. This results in a compact, cost-effective construction which requires less parts for assembly and mounting and is easy to produce and easy to assemble. The sensing device is arranged to provide reliable and precise voltage and current measurements and is suitable for use in a great variety of applications, including GIS of HV or MV substations.

For example, the sensing device 17 may be positioned inside the transmission line 6 of the GIS 1 and attached thereto using the radial legs 26 of the pipe coupling 24. Advantageously, both the voltage sensor 21 and the current sensor 22 can be located directly in the insulating gas which fills the internal cavity 19 of the transmission line 6.

As may be seen from Figs. 2 and 3, the current sensor 22 may be positioned on the voltage sensor 21, such that, when the sensing device 17 is finally assembled inside the transmission line 6, one of the protective plates 48a, 48b, in present case the protective plate 48a, comes into contact with an inwardly facing radial surface 59 of the pipe coupling 24 that forms one of the flanks of the groove 29. By this contact, the protective screen 47 and the reference plate 34 may be electrically connected to the grounding pipe 18 via the pipe coupling 24, thereby making the electric potential of the protective screen 47 and the reference plate 34 equal to the electric potential of the grounding pipe 18, that is the ground potential.

In other embodiments, instead of or in addition to the direct flat connection between the protective plate 48a and the radial surface 59 of the pipe coupling 24, the grounding connection may be established via a wired connection or using elastic contacting blades 60. In the embodiment of Fig. 2, such contacting blades 60 are shown as being interposed between the cylindrical plate 49 of the protective screen 47 and an inwardly facing surface of the pipe coupling 24. The contacting blades 60 may be provided at any suitable position to contact the protective screen 47 or the reference plate 34 to the pipe coupling 24 or the grounding pipe 18. The contacting blades 60 are made of an electrically conductive material, such as copper, and provide suitable mechanical characteristics and electrical conductivity to assure a stable mechanical and electrical contact for grounding purposes.

As may be seen from Figs. 3 and 4, the sensing device 17 may further comprise at least one temperature sensor 61. The temperature sensor 61 may be attached to the current sensor 22 at a predetermined position and configured to measure a temperature in a corresponding predetermined volume relative to the current sensor 22 and the voltage sensor 21. In present case, the temperature sensor 61 is attached to the radially outer side of the main plate 39 or the cylindrical plate 49. The temperature sensor 61 might also be positioned at an end face 44a, 44b of the main plate 39 or a protective plate 48a, 48b or may be positioned at and attached to the voltage sensor 21, in particular the substrate 33 thereof. Two or more temperature sensors 61 may be provided at circumferentially spaced positions, if desired.

As is further indicated in Fig. 3, each of the voltage sensor 21, the current sensor 22 and the temperature sensor 61 comprises wires 62 that connect the sensors 21, 22, 61 to a computer device 63 that may be located outside the transmission line 6. For example, the computer device 63 might be arranged in the control box 12 of the GIS 1 shown in Fig. 1. The wires 62 allow to transfer the measurement signals provided by the sensors 21, 22, 61 to the computer device 63.

The computer device 63 is configured to compute the value of the conductor-to-pipe voltage between the grounding pipe 18 and the conductor 16 from the voltage signal outputted by the voltage sensor 21 and the value of the current flowing through the conductor 16 from the output signal provided by the current sensor 22. It should be noted that the current sensor 22 provides a voltage signal that is proportional to the first derivative of the primary current flowing through the conductor 16. The computer device 63 may then obtain the corresponding current measurement by integrating the output signal provided by the current sensor 22.

The computer device 63 may further be configured to correct the measured conductor-to-pipe voltages and current measurements using the sensed temperature signals provided by the temperature sensor(s) 61. In doing so, the computer device 63 may compensate for the effects of the temperature fluctuations on the geometry of the sensor components, that is the thermal expansion and contraction thereof, and other properties like temperature dependent resistance variations.

The wires 62 may be conveyed through one or more holes passing through the pipe coupling 24 and/or the grounding pipe 18, such as the through hole 31. As an alternative, the measurement signals output by the sensors 21, 22 and 61 might be transmitted wirelessly to the computer device 63 located outside the transmission line 6.

Fig. 6 shows an alternative embodiment comprising two RECT based current sensors 22 which are attached to a single voltage sensor 21, thereby forming a sensing device 17 which is placed around an individual inductor 16. The two current sensors 17 are superimposed axially and are supported against each other while being generally insulated from one another. Each individual current sensor 22 is substantially formed in the manner as described above in connection with the embodiment of the current sensor 22 shown in Figs. 2-5. In the present example, the two current sensors 22 are arranged back-to-back, with the main plates 39 of the two current sensors 22 positioned immediately adjacent each other in the axial direction and only separated from each other by a single layer of insulating material 52. The protective plates 48a, 48b that would be interposed between the two main plates 39 may be omitted.

The two current sensors in Fig. 6 may be electrically connected to each other either in series or in parallel. In the series connection, the two current sensors 22 provide a larger cross-sectional area of the main plate 39 and the Rogowski coil 41, which increases sensitivity of the resulting combined current sensor 22 with reduced radial dimensions thereof. In view of the space constrains in an GIS, such an embodiment which increases the axial dimension of the current sensor 22, while reducing its radial dimension, has proven to be beneficial.

As an alternative, the two current sensors 22 may be electrically connected in parallel. The parallel connection of the current sensors 22 offers redundancy to enhance reliability of the current measurements and to enhance operational security in case one of the current sensors 22 fails.

If two current sensors 22 are provided, a temperature sensor 61 may be assigned to each current sensor 22 and the temperature sensors 61 may be positioned offset to each other in the circumferential direction to facilitate handling, including routing of wires and connecting the temperature sensors 61 to the computer device 63.

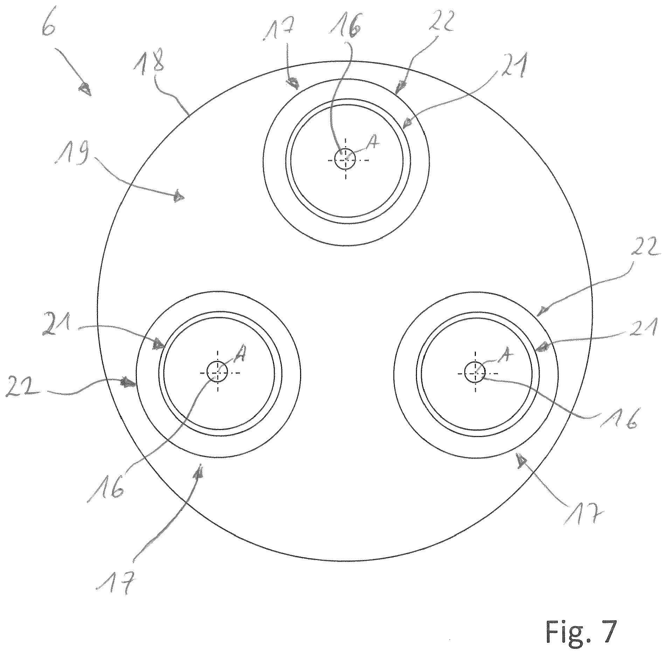

Referring now to Fig. 7, a schematic cross-sectional view of a transmission line 6 according to another embodiment of the invention is shown, in a plane orthogonal to the longitudinal or main axis A of the transmission line 6. In this embodiment, the transmission line 6 is arranged for a three-phase system, where three primary conductors 16 are provided within the grounding pipe 18. The conductors 16 extend along the longitudinal or main axis A and are spaced apart from one another in the circumferential direction. Each conductor 16 corresponds to a respective electric phase and transmits a phase current from one side to the other side of the transmission line 6.

A sensing device 17 according to any of the embodiments described above is associated with each primary conductor 16, as shown in Fig. 7. Each sensing device 17 comprised of the voltage sensor 21 including the substrate 3 with the reference and sensing plates 34, 36 and the current sensor 22 including the main plate 39 and the Rogowski coil 41 is arranged exclusively around the corresponding conductor 16 between the grounding pipe 18 and the corresponding conductor 16.

The details regarding the mounting of the sensing devices 17 and the conductors 16 in the transmission line 6 are omitted in the schematical figure 7 for clarity. Generally, the sensing devices 17 may be attached to the transmission line 6 in the manner as shown and described in connection with Figs. 2 and 3 above. The conductors 16 may be supported in the transmission line 6 by corresponding flanges (not shown). There are many different ways to support the conductors 16 and corresponding sensing devices 17 in the internal cavity 19 of a three-phase transmission line 6.

A sensing device 17 is provided, comprising: a capacitive voltage sensor 21 comprising a substrate 33, a reference plate 34 and a sensing plate 36, each being cylindrical and coaxial relative to a main axis A of the sensing device 17, the reference plate 34 arranged on a radially outer side of the substrate 33 and the sensing plate 36 concentrically arranged on a radially inner side of the substrate 33, the reference plate 34 and the sensing plate 36 each being made of an electrically conductive material, the substrate 33 being made of an electrically insulating material, the voltage sensor 21 being adapted to output a voltage signal representative of a voltage value between the reference plate 34 and the sensing plate 36; and a Rogowski coil current sensor 22, the current sensor 22 comprising a toroidal main plate 39 centered on the main axis A and made of an electrically insulating material and a ring shaped Rogowski coil 41 carried by the main plate 39, the current sensor 22 being adapted to output a signal representative of a current flowing through a conductor 16 encircled by the Rogowski coil 41. The current sensor 22 is arranged to concentrically encircle the voltage sensor 21 and is fixedly attached to the reference plate 34 of the voltage sensor 21, thereby forming a one-piece construction of the sensing device 17 comprising the current sensor 22 supported directly on the voltage sensor 21.

## Claims

1. A sensing device (17) comprising:
a capacitive voltage sensor (21) comprising a substrate (33), a reference plate (34) and a sensing plate (36), the substrate (33), the reference plate (34) and the sensing plate (36) each being cylindrical and coaxial relative to a main axis (A) of the sensing device (17), the reference plate (34) arranged on a radially outer side (35a) of the substrate (33) and the sensing plate (36) concentrically arranged on a radially inner side (35b) of the substrate (33), spaced from the reference plate (34), the reference plate (34) and the sensing plate (36) each being made of an electrically conductive material, the substrate (33) being made of an electrically insulating material, the voltage sensor (21) being adapted to output a voltage signal representative of a voltage value between the reference plate (34) and the sensing plate (36); and
a Rogowski coil current sensor (22), the current sensor (22) comprising a toroidal main plate (39) centered on the main axis (A) and made of an electrically insulating material and a ring shaped Rogowski coil (41) carried by the main plate (39), wherein the Rogowski coil (41) comprises a winding (42) which is made of an electrically conductive material and includes a plurality of winding arms (43) arranged on radially extending end faces (44a, 44b) of the main plate (39) and extending radially relative to the main axis (A) spaced from each other in a circumferential direction, and metallized holes (46) which pass through the main plate (39) and electrically connect the winding arms (43) located on one end face (44a) of the main plate (39) to the winding arms (43) located on another end face (44b) of the main plate (), the current sensor (22) being adapted to output a signal representative of a current flowing through a conductor (16) encircled by the Rogowski coil (41);
wherein the current sensor (22) is arranged to concentrically encircle the voltage sensor (21) and is fixedly attached to the reference plate (34) of the voltage sensor (21), thereby forming a one-piece construction of the sensing device (17) comprising the current sensor (22) supported directly on the voltage sensor (21).

2. The sensing device (17) of claim 1, wherein the substrate (33) of the voltage sensor (21) is a flexible circuit board and the reference plate (34) and the sensing plate (36) are metallic strips printed on the flexible circuit board.

3. The sensing device (17) of claim 2, wherein the flexible circuit board is made of a flame resistant epoxy material, preferably a glass-reinforced epoxy laminate material, in particular FR-4.

4. The sensing device (17) of anyone of the preceding claims, wherein the main plate (39) of the current sensor (22) is a flexible circuit board and the winding arms (43) of the Rogowski coil (41) are conductive traces printed on the end faces (44a, 44b) of the flexible circuit board.

5. The sensing device (17) of claim 4, wherein the flexible circuit board is made of a flame resistant epoxy material, preferably a glass-reinforced epoxy laminate material, in particular FR-4.

6. The sensing device (17) of anyone of the preceding claims, wherein the reference plate (34) and the sensing plate (36) are made of copper or aluminum and wherein the winding arms (43) and the metallized holes (46) are made of copper or aluminum.

7. The sensing device (17) of anyone of the preceding claims, wherein the substrate (33) of the voltage sensor (21) and the main plate (39) of the current sensor (22) are made of the same flexible circuit board material and wherein the reference plate (34), the sensing plate (36) and the winding (42) of the Rogowski coil (41) are made of the same metallic material.

8. The sensing device (17) of anyone of the preceding claims, wherein the current sensor (21) is soldered to the reference plate (34) of the voltage sensor (21).

9. The sensing device (17) of anyone of the preceding claims, wherein the current sensor (21) further comprises a metallic protective screen (47) arranged to protect the main plate (39) and the winding (42) of the Rogowski coil (41) from possible damage and to shield the Rogowski coil (41) against external electric fields, wherein the protective screen (47) includes protective plates (48a, 48b) which are arranged axially on either side of the main plate (39) to extend parallel to the main plate (39) and coaxial with the main axis (A) of the sensing device (17).

10. The sensing device (17) of claim 9, wherein the metallic protective screen (47) is arranged to substantially surround the main plate (39) and the winding (42) of the Rogowski coil (41), wherein a portion (53) of the reference plate (34) forms a radial inner part (56) of the metallic protective screen (47) and is arranged to shield the Rogowski coil (41) from the sensing plate (36).

11. The sensing device (17) of claim 10, wherein the protective plates (48a, 48b) are soldered to the reference plate (34) using an electrically conductive solder.

12. The sensing device (17) of claim 11, wherein a part of the metallic material of the protective plates (48a, 48b) is omitted or removed from a radially inner portion (57) of the protective plates (48a, 48b) prior to soldering the protective plates (48a, 48b) to the reference plate (34) to reduce conductivity at an interface of the protective plates (48a, 48b) and the reference plate (34) to facilitate reducing heat input during the soldering process.

13. The sensing device (17) of anyone of the preceding claims, further comprising at least one temperature sensor (61) attached to the current sensor (2) at a predetermined position and configured to measure a temperature in a corresponding predetermined volume relative to the current sensor (22) and the voltage sensor (21).

14. The sensing device (17) of anyone of the preceding claims, comprising two current sensors (22) which are superimposed axially and are supported against each other, the two current sensors (22) being electrically connected to each other either in series or in parallel.

15. A transmission line (6), in particular a transmission line (6) of a gas insulated switchgear (1), comprising:
a grounding pipe (18) made of an electrically conductive material, the grounding pipe (18) defining an internal cavity (19) that is filled with a dielectric gas;
one or more conductors (16) arranged in the internal cavity (19) within the grounding pipe (18) and made of an electrically conductive material, the grounding pipe (18) and each conductor (16) extending along a same longitudinal axis (A), each conductor (16) being spaced apart from the grounding pipe (18); and
a sensing device (17) according to anyone of the preceding claims assigned to each of the one or more conductors (16), the sensing device (17) arranged around the corresponding conductor (16) between the grounding pipe (18) and the corresponding conductor (16) in the internal cavity (19) filled with the dielectric gas.
